Europäisches Patentamt

European Patent Office

Office européen des brevets

(11) Publication number: **0 094 501**
**B1**

(12) **EUROPEAN PATENT SPECIFICATION**

(45) Date of publication of patent specification: **01.04.87**

(21) Application number: **83103295.8**

(22) Date of filing: **05.04.83**

(51) Int. Cl.⁴: **G 03 B 41/00**

(54) **Methods of inspecting pattern masks.**

(30) Priority: **11.05.82 US 377102**

(43) Date of publication of application:
**23.11.83 Bulletin 83/47**

(45) Publication of the grant of the patent:
**01.04.87 Bulletin 87/14**

(84) Designated Contracting States:
**DE FR GB**

(56) References cited:
**WO-A-79/00876**
**US-A-3 909 602**
**US-A-4 218 142**

**IBM TECHNICAL DISCLOSURE BULLETIN, vol. 16, no. 11, April 1974, pages 3660-3661, New York; USA; J.S. KUNEY: "Design verification and defect detection"**

**PATENTS ABSTRACTS OF JAPAN, vol. 4, no. 177(P-39)(659), 9th December 1980; & JP - A - 55 121 137 (CHO LSI GIJUTSU KENKYU KUMIAI) 18-09-1980**

(73) Proprietor: **International Business Machines Corporation**
**Old Orchard Road**
**Armonk, N.Y. 10504 (US)**

(72) Inventor: **Vettiger, Peter**
**Langmoosstrasse 33**
**CH-8135 Langnau a/a (CH)**
Inventor: **Wilson, Alan Dickson**
**Chestnut Ridge Road**
**Mt Kisco New York 10549 (US)**

(74) Representative: **Lewis, Alan John**
**IBM United Kingdom Limited**
**Intellectual Property Department**
**Hursley Park Winchester**
**Hampshire SO21 2JN (GB)**

(56) References cited:
**IEEE JOURNAL OF SOLID-STATE CIRCUITS, vol. SC-15, no. 4, August 1980, pages 386-396,**

**IEEE, New York; USA; Y. TARUI: "Basic technology for VLSI (Part II)"**

## Description

The invention relates to methods of inspecting or testing pattern masks, such as are used in the production of printed circuits.

U.S. Specification No. 4,218,142 (Kryger) describes a method of testing a mask, such as a photo-lithographic mask used in the prosecution of printed circuits and comprising optically transparent and opaque areas. The kryger method comprises incrementally scanning the mask with a laser beam focussed in a spot having approximately the size of deflects to be detected, detecting the transmitted light to form an electrical signal representing an image of the scanned mask and comparing the image signal with a master signal to detect differences therebetween. Such differences are indicative of defects.

The Applicants have appreciated that the Kryger method has disadvantages in that his approach does not test the mask in the same environment in which the mask is to be used. As a result, transient defects which do not survive through the developed print are detected. In addition, other defects that may be added or changed are not detected.

IBM Technical Disclosure Bulletin, Vol. 16, No. 11, April 1974, pages 3660 and 3661 discloses a method of testing or inspecting a glass mask by generating two single segment masks, making positive and negative photoprints thereof, aligning the positive print of one mask and the negative print of the other, and inspecting to determine if light passes through any part of them.

IEEE Journal of Solid-State Circuits, Vol. SC-15 (1980) August, No. 4, pages 386 to 396 describes basic technology for VLSI, including high-speed electron-beam pattern delineators, electron-beam mask inspection and electron-beam projection systems. A conductive mask is described as used because of its electron-beam backscattering effect.

It is a primary object of this invention to provide an improved method of testing or inspecting a photolithographic mask.

It is another object of this invention to provide a method of testing or inspecting masks in which the contrast for optimum detection of defects can be optimized by material selection.

It is yet another object of this invention to provide a method of testing or inspecting a mask as it is used in situ.

It is still a further object of this invention to provide a method of testing or inspecting the mask without subjecting the mask to additional defects introduced by the inspection process.

It is yet a further object of this invention to provide a method of testing or inspecting masks that eliminate false defects and enhances the true defects.

Accordingly, the invention provides a method of testing or inspecting a photolithographic mask comprising a pattern of areas of contrasting transparency formed by an electron beam scanned over a blank of the mask and controlled in accordance with write-pattern-data, said method being characterised by using the mask to make a copy of the mask pattern on a substrate, the copy being readable by an electron beam, scanning the copy with an electron beam controlled by the same write-pattern-data, and detecting points of coincidence or non-coincidence between the scanning beam pattern and the copy pattern.

The invention includes the steps of forming a print of the electron beam fabricated mask and then inspecting the print by writing the same electron beam pattern or complement thereof on the print and detecting pattern coincidence or non-coincidence with a vector scan system. In a preferred embodiment, the mask is printed on a semi-conducting substrate such as a silicon wafer in the same manner that the mask is normally used. For example, the wafer is coated with a photoresist suitable for a lift-off procedure. Removal of the lift-off photoresist leaves a print of the mask in a material such as fold having a high contrast to electrons used in the vector scan. A corresponding electron beam pattern formed from the same pattern data used to form the mask is overlaid and registered with the print. The points of coincidence of noncoincidence of the electron beam pattern with respect to the print are then detected by utilizing the vector scan system.

Methods in accordance with the invention using a printed sample of the mask for inspection result in several desirable features. One advantage is that the contrast for inspection can be selected by proper materials and system parameters for optimum detection of defects. Another advantage is that the mask itself is really tested as it is used, that is, in situ, and thus it is a real evaluation of what defects find their way onto the wafers. Another advantage is that the mask can remain in production and is not subject to additional defects introduced by the inspection process. A further advantage is that the inspection can be done automatically by electron beams without the need for special coatings on the mask which could possibly add new defects. A further advantage is that because of the speed of the electron beam system, several "images" can be compared to one another to eliminate the false defects and enhance the true defects.

The invention will now be further described with reference to the accompanying drawings, in which:—

FIG. 1A is a cross-sectional view of a mask to be tested;

FIGS. 2A—2D are cross-sectional views showing the steps of forming a print from the mask;

FIG. 3 is a block diagram in outline of a mask inspection system for one embodiment of method according to the invention; and

FIG. 4 is a plan view of a substrate which has been exposed through a mask.

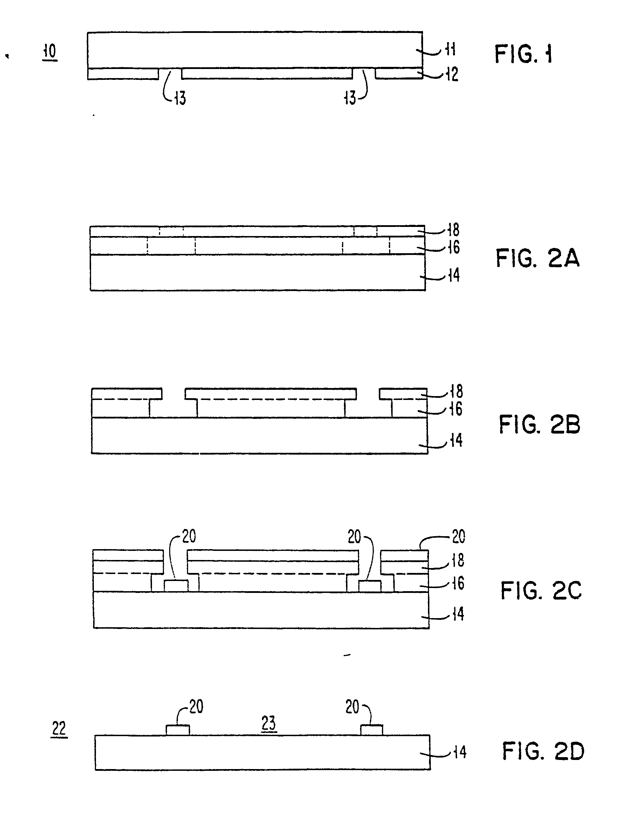

As shown in Fig. 1, a mask 10 consists of a glass substrate 11 and a metal pattern 12. A preferred metal for the pattern 12 is chromium. The mask 10 is to be inspected to see if there are any defects in the pattern 12.

A print of the mask 10 is formed or printed on a semiconducting substrate 14 such as a silicon wafer by conventional techniques. Typically this includes using, for example, two lift-off photoresist layers 16 and 18 which have different optical sensitivities. After the photoresist layers 16 and 18 are exposed as shown in Fig. 2A, they are developed to provide the structure shown in Fig. 2B. A layer 20 of a high contrast material, that is, having a high contrast to electrons used in a subsequent vector scan at a suitable operating voltage, is deposited on top of and in the openings in photoresist layer 18 as shown in Fig. 2C. The photoresist layers are then removed to provide the print 22. The print 22 consists of the portion of the metal layer 20 on the surface of the semiconducting substrate 14 as shown in Fig. 2D. A preferred material for the printed pattern 20 is gold. Gold provides a high contrast with the substrate material 14 in the video signal subsequently produced. Because of the use of the high contrast material such as gold and the use of a high electron beam current, it is not necessary for signal averaging or complex signal processing in the vector scan system.

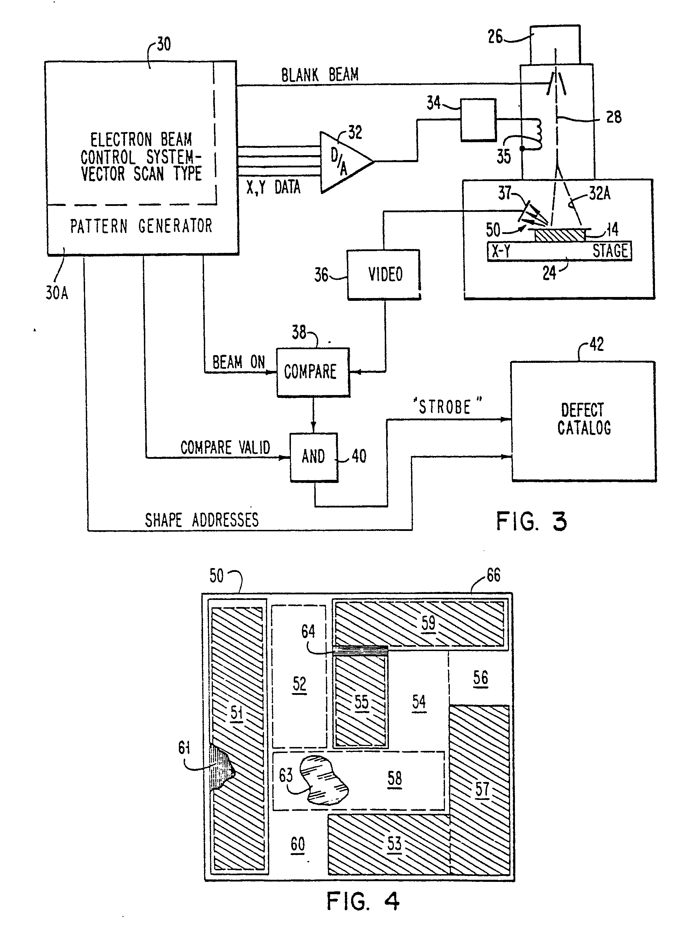

A diagram of a system for performing a method of inspecting a mask embodying the invention is shown in Fig. 3. The print 20 of the mask (not shown in Fig. 3) is on the substrate 14. The substrate 14 is positioned on an X, Y stage 24 or other mechanism for controlled movement of the substrate 14 separately in the Y direction and the X direction. The X, Y movements permit the entire area of the mask print on the substrate 14 to be moved into and through an inspection zone. A source 26 provides an electron beam 28. The beam is controlled by scan control means 30 to sweep across a portion of the mask print on the substrate 14 on stage 24.

The electron beam 28 is deflected by deflection coil 35 energised through digital to analog converter 32 and amplifier 34. The beam is deflected in a vector scan mode so as to scan theprinted shapes on the substrate 14. The shapes on the substrate 14 scatter electrons to the detector 37 and the detected signals are amplified by the video amplifier 36. The pattern generator 30A which is "rewriting" the shape which is being checked/verified generates a "beam-on" signal which is compared with the back-scattered signal 50 via comparator 38. If a defect such as a "missing shape" is found, then the pattern generator 30A would provide a high signal and, because of the absence of the shape no backscattering occurs, the detector 37 would provide no video signal. Consequently, the compare is positive (no match) — a defect was found. The output from the compare 38 is validated in AND circuit 40 by coincidence of "compare valid" and compare 38 output. The result is stored in memory 42 along with the addresses (digital) of the shape scan so that the defect can be catalogued for further analysis.

Thus, in this example a mask, which has been fabricated by scanning an original opaque mask blank with an electron beam controlled in accordance with stored data representative of the mask to be fabricated, is tested by a method that comprises forming a print of the mask, for example by fold deposition through the mask, and then inspecting the print by writing the same electron beam pattern or the complement thereof on the print and detecting pattern coincidences or noncoincidences with a vector scanning system.

The advantage of this mask inspection system over conventional systems is the inherent speed of electron beam systems. In this novel application of mask inspection, an inspection is made, not of the original mask, but of a copy printed from the mask by, for example, X-ray lithography. The reason for examining the print or copy of the mask rather than the mask itself is that the concern is not with mask defects per se, but rather with printable mask defects. The defects which are printable can differ markedly from the defects of the mask itself because light atomic dirt particles may not print as defects at all, whereas they would be significant defects when viewed in an optical microscope. On the mask copy repeating defects can be looked for — a defect which does not repeat copy to copy is a copy defect and not inherent in the mask itself. A repeating defect is a mask defect.

The wafer or sample 14 is placed in the vector scan system shown in Fig. 3 and the print on the sample 14 is registered to the system using wafer and chip mapping routines to scale the system parameters to those of the wafer such as size, orthogonality etc. After this is done, the vector scan system will effectively overlay the printed mask pattern with a virtual pattern written when the system is instructed to write.

The conditions for pattern "write" to do the inspection i.e. to overlay the printed mask pattern with the virtual pattern, such as the beam clock rate, step size, etc., can be set to optimize the relationship between resolution at time of inspection and time to do the inspection. The pattern to "write" for inspection is really two patterns; the first pattern is the positive image, exactly what was clear on the mask (13 in Fig. 1), and the second pattern is the negative image, that is, what was opaque 12 on the mask. The first pattern will test for the opaque areas 12 in the mask that should be clear and the second pattern will test for the clear areas 13 in the mask (holes) that should be opaque.

When the video from the substrate print differs at the sample time from the beam on signal, then the compare circuit 38 will produce a positive indication of a defect. The size of the defect can be automatically met by recording the digital addresses of the electron beam and laser system automatically using zone detection circuits or simply dumping the digital data into a memory. The size of the defect detected, its smallness, can and would be set by the beam probe conditions and the beam stepping size much the same way it is now in writing a mask or wafer. Probably one-half the writing resolution is needed for the inspection, that is, twice the beam stepping distance, and thus inspection for both types of defects should take about one-half the time to write the original mask. It should be noted that the technique disclosed here does not detect errors in the digital input data for writing the original mask, but rather defects introduced by the wet process, resist, dirt, etc.

It is probable that defects will be discovered en masse printed on the wafer that are not really in the mask, but are associated with the wafer and resist and lift-off of the high contrast material. These are eliminated by inspecting two or more wafers, that is maybe two fields or more on the same wafer, and automatically comparing further the digital zones of the two sets of errors after the mask or groups of the mask have been inspected. Some interesting signal processing can be done at this point to detect true defects and reject random defects that are associated with the transfer process from mask to inspecting wafer. Several options are available. First, compare after the inspection is complete, the digital addresses of found errors/defects with some tolerance limit, for example, three microns that is 3 μm. If there is good agreement of the digital addresses, then it is probable that the mask is bad. Secondly, if more than two fields are compared, then digital signal enhancement can be used where the frequency of occurrence of a particular error address is recorded. It is expected that the accuracy of proper defect detection and recording is substantially better than that presently obtained on current production lines.

Fig. 4 is a plan view of a printed copy of a mask to be tested, the areas 61 and 63 corresponding to defects in the mask. The area 64 is a buffer area.

"When inspecting for mask defaults the vector scan electron beam is directed to scan the pattern areas of the print as illustrated in Fig. 4 as follows. Suppose the mask area is that shown within the bold line region 50. The areas 51, 53, 55, 57 and 59 (shown as rectangles but do not have to be, could be polygons) are the intended clear areas of the mask. The electron beam scans an area slightly smaller than say area 51 and a default 61 is detected as the absence of a section of the area 51. The other "clear areas" 53, 55, 57 and 59 are likewise scanned and no defaults detected in this example. Next, the opaque areas 52, 54, 56, 58 and 60 are scanned. In area 58 a large pin hole 63 is detected. A buffer area 64 equal to twice tolerance zone 66 is unscanned."

## Claims

1. A method of testing or inspecting a photolithographic mask comprising a pattern of areas of contrasting transparency formed by an electron beam scanned over a blank of the mask and controlled in accordance with write-pattern-data, said method being characterised by using the mask to make a copy of the mask pattern on a substrate, the copy being readable by an electron beam scanning the copy with an electron beam controlled by the same write-pattern-data, and detecting points of coincidence or non-coincidence between the scanning beam pattern and the copy pattern.

2. A method as claimed in claim 1, further characterised by forming a plurality of copies on the substrate and comparing a point of coincidence or non-coincidence on one copy with at least one of said other copies.

3. A method as claimed in claim 1, or 2, in which a vector scan system is used to detect points of coincidence and non-coincidence.

4. A method as claimed in claim 1, 2 or 3, further characterised in that instead of a corresponding electron beam pattern the electron beam is controlled by a complement from said pattern data.

5. A method as claimed in any one of claims 1 to 4, in which the copied pattern is made of gold.

## Patentansprüche

1. Verfahren zum Testen bzw. Kontrollieren einer photolithographischen Maske mit einem Muster von Flächen gegensätzlicher Transparenz, welches durch einen Elektronenstrahl gebildet wird, der eine Leerstelle der Maske abtastet und entsprechend der Schreib-Muster-Daten kontrolliert wird, dadurch gekennzeichnet, daß die Maske für das Erstellen einer Kopie der Maskenpatrone auf einem Substrat verwendet wird, wobei die Kopie von einem Elektronenstrahl gelesen werden kann, welcher die Kopie mit einem von den gleichen Schreib-Muster-Daten kontrollierten Elektronenstrahl abtastet, und daß zwischen dem abtastenden Strahlenmuster und dem Kopiemuster übereinstimmende bzw. nichtübereinstimmende Punkte festgestellt werden.

2. Verfahren nach Anspruch 1, dadurch gekennzeichnet, daß eine Vielzahl von Kopien auf dem Substrat gebildet wird und ein übereinstimmender bzw. nichtübereinstimmender Punkt auf einer Kopie mit mindestens einer der anderen Kopien verglichen wird.

3. Verfahren nach Anspruch 1 oder 2, dadurch gekennzeichnet, daß übereinstimmende bzw. nichtübereinstimmende Punkte mit Hilfe eines Vektor-Abtastsystems festgestellt werden.

4. Verfahren nach Anspruch 1, 2 oder 3, dadurch gekennzeichnet, daß der Elektronenstrahl nicht mit einem entsprechenden Elektronenstrahlmuster, sondern durch ein Komplement der Musterdaten kontrolliert wird.

5. Verfahren nach einem der Ansprüche 1 bis 4, dadurch gekennzeichnet, daß die kopierte Maskenpatrone aus Gold besteht.

## Revendications

1. Méthode de test ou de contrôle de masques photo-lithographiques comprenant un motif de zones à transparence contrastée formé au moyen d'un faisceau électronique balayant un espace blanc du masque et contrôlé conformément à des données de motif d'écriture, méthode caractérisée par l'utilisation du masque pour faire une copie du motif de masque sur un substrat, la copie étant lisible par un balayage par faisceau électronique de la copie avec un faisceau électronique commandé par les mêmes données de motif d'écriture, et la détection de points de coïncidence ou de non coïncidence entre les motifs de faisceau de balayage et les motifs de la copie.

2. Méthode selon la revendication 1 caractérisée en outre par le formation d'une pluralité de copies sur le substrat et la comparaison d'un point de coïncidence ou de non coïncidence sur une copie avec au moins une des autres copies.

3. Méthode selon la revendication 1 ou 2 dans laquelle un système de balayage vectoriel est utilisé pour détecter des points de coïncidence et de non coïncidence.

4. Méthode selon les revendications 1, 2 ou 3 caractérisée en outre, en ce que, à la place d'un motif de balayage électronique correspondant, le faisceau électronique est contrôlé par un complément des données de motif.

5. Méthode selon l'une quelconque des revendications 1 à 4 dans laquelle le motif copié est en or.

FIG. 1

FIG. 2A

FIG. 2B

FIG. 2C

FIG. 2D

FIG. 3

FIG. 4